# EUROPEAN PATENT SPECIFICATION

(11) **EP 1 006 666 B1**
(45) Date of publication and mention of the grant of the patent: **26.10.2005**
(21) Application number: 98204040.4
(22) Date of filing: 30.11.1998
(51) Int. Cl.: H04B 1/16, H04B 1/10

(54) **Method for noise reduction in the reception of RF FM signals**
Verfahren zur Rauschverminderung beim Empfang eines HF FM Signals
Procédé de réduction du bruit pour la réception de signaux HF modulés en fréquence

(43) Date of publication of application: 07.06.2000
(73) Proprietor: SIEMENS AKTIENGESELLSCHAFT, 80333 München (DE)
(72) Inventor: Sessink, Franciscus Josephus Alphonsus Maria, 5600 JB Eindhoven (NL)

(56) References cited:
- US-A- 4 914 715
- US-A- 5 036 543

## Description

The invention relates to a method for noise reduction during FM reception comprising the steps of:
- attenuating a detected audio signal,
- deriving a fieldstrength indicative muting control signal from an IF signal,
- controlling the step of attenuating the audio signal using the muting control signal,
when the fieldstrength decreases below a certain threshold level and a receiver for executing the method. A method for noise reduction is known from US-A-4,914,715 said method changing the timeconstant of a lowpass filter of the receiver.

A receiver executing such method is known e.g. from US patent 5,410,751 and comprises an RF front end for tuning the receiver onto a wanted RF FM signal and demodulating the received RF FM signal into an IF signal, said RF front end being subsequently coupled to a selective IF amplifier for selecting and amplifying the IF signal and an FM detector for detecting the IF signal to obtain its baseband FM modulation signal, comprising an audiosignal. The baseband FM modulation signal is supplied to a muting circuit, which under control of the fieldstrength indicative muting control signal is to suppress FM demodulation noise, hereinafter also indicated as FM interstation noise of FM noise, occurring at the output of the FM detector. The muting control signal is derived from the IF signal by measuring the level thereof in an IF level detector coupled to the IF amplifier and filtered and/or smoothened in a lowpass filter following the IF level detector.

FM noise occurring in the baseband FM modulation signal at the output of the FM detector and therewith also in the audiosignals derived therefrom, increases inversely to the fieldstrength of the received FM RF signal. In particular FM RF signals decreasing below a certain threshold value give rise to a sharp increase in FM noise. In the known receiver, this FM noise is suppressed by an attenuation or mute of the baseband FM modulation signal in the muting circuit every time the lowpass filtered IF signal level drops below a certain threshold value. However, the IF signal level is not always one to one related to the fieldstrength of the received RF FM signal. Due to the passband frequency characteristic of the IF selectivity, said IF signal level not only varies with the fieldstrength of the received RF FM signal, but also with the deviation of the momentary frequency of the IF FM signal from the IF carrier frequency. Dependent on the magnitude of deviation, filter side suppression may occur, reducing the IF signal level considerably also in the absence of FM noise and even when receiving undisturbed RF FM signals of moderate strength. Such frequency deviation dependent reductions in the IF signal level, in particular when occurring with FM RF signals received with low fieldstrength, may give rise to unwanted mute actions and signal attenuations, resulting in distortions of the useful audiosignal.

In the known receiver the lowpass filter following the IF level detector at the output of the IF amplifier smoothens the muting behaviour and introduces a timeconstant in the mute control, therewith delaying the mute control to some extent. The choice of this timeconstant is critical with regard to the balance between signal distortion on the one hand and audible FM noise on the other hand. The lower the cut-off frequency of the lowpass filter, the larger the timeconstant and delay in the mute control, the less mute actions and the less distortions will occur, but also the less alert FM noise will be suppressed, therewith FM noise becoming increasingly audible, and vice versa.

It is an object of the invention to introduce an additional degree of freedom in the mute control providing a solution to the above conflicting requirements to the timeconstant of the mute control.

A method of fieldstrength dependent noise reduction during FM reception as mentioned hereabove according to the invention is therefore characterized by a timeconstant in the mute control being increased with an increasing deviation of the momentary frequency of the received FM signal from the FM carrier frequency and vice versa.

The method according to the invention differentiates in its mute responsiveness to reductions in the IF signal level at the output of the IF selectivity between reductions due to filter side suppression and those due to decreasing fieldstrength. It is based on the recognition that IF signal level reductions due to filterside suppressions are mainly caused by undisturbed, low modulation frequencies and do not need to effect any muting. IF signal level reductions caused otherwise result mainly from decreasing fieldstrength giving rise to audible FM noise, which need to be muted.

By applying this measure according to the invention, the timeconstant of the lowpass filter is decreased to a small value, therewith making the mute control highly responsive to IF level reductions, when the modulation frequency is varying within the pass band of the IF selectivity. This results in an alert and adequate muting of FM noise. In the following muting is to be understood as any decrease in signal gain or increase in signal attenuation, be it stepwise or gradual. The timeconstant of the lowpass filter and therewith also that of the mute control is considerably increased when the momentary frequency of the IF signal deviates from the carrier frequency to such extent that due to filter side suppression the IF signal level is noticeably reduced. This prevents unnecessary mute actions and therewith distortions of the useful audiosignals from occurring.

Preferably a timeconstant control signal reflecting the deviation of the momentary frequency of the IF signal from the IF carrier frequency is derived from the level of detected baseband FM modulation signal being obtained by means of a rectifier having lowpass filter functionality for rectifying and selecting the detected baseband FM modulation signal being supplied from the output of the FM detector to the rectifier.

In another preferred embodiment of the invention, a non-linear amplifier is used to amplify the timeconstant control signal with a non-linear gain allowing to adjust more accurately the timeconstant variation of the mute control to the occurrence of FM noise as a function of the deviation of the momentary frequency of the IF signal from the IF carrier frequency.

In yet another preferred embodiment of such receiver using analog circuitry the FM modulation signal level detector comprises subsequently coupled between said output of the FM detector and the timeconstant control terminal of the lowpassfilter, a DC blocking filter and said rectifier. The DC blocking filter is to eliminate any DC component in the baseband FM modulation signal which may result e.g. from tolerance differences in the circuitry elements of in particular the IF amplifier. In the receiver shown, the rectifier is provided with a post detection lowpass filter with averaging function.

The invention will now be further explained by way of non-limitative example with reference to the Figures shown in the accompanying drawings, whereby
Figure 1 shows an FM receiver executing the method according to the invention.
Figures 2a-2d show how in a prior art FM receiver selective IF amplifier side suppression would initiate a muting operation affecting the audio signal, in which:

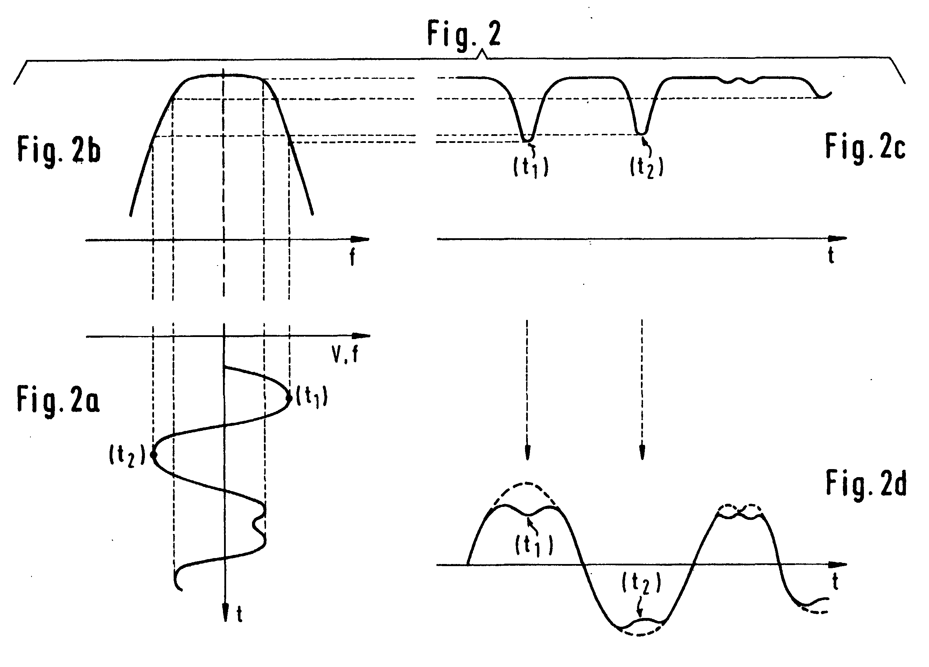

Figure 2a shows an example of a time dependent variation of the momentary IF modulation frequency;
Figure 2b shows an IF filter response;
Figure 2c shows the time dependent signal level variation at the output of the IF filter;
Figure 2d shows the deteriorating effect of the muting operation on the audiosignal.

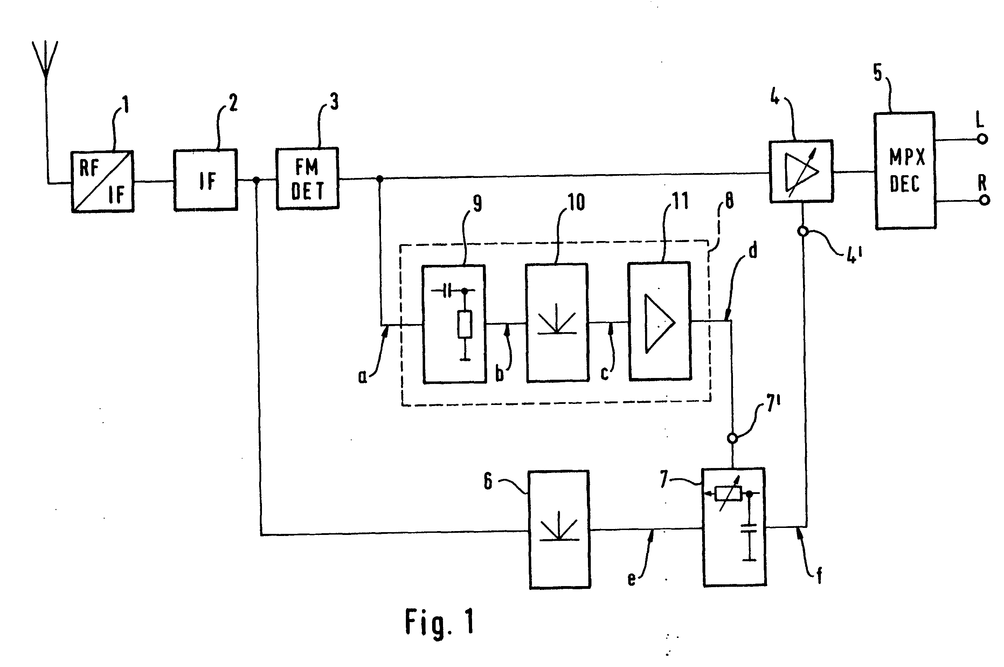

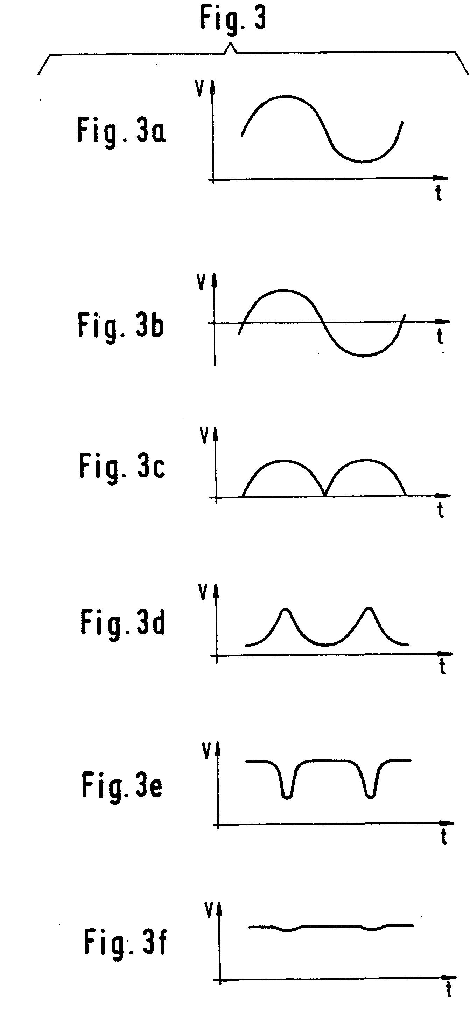

Figure 3a-3f show the mute response in the Figure 1 FM receiver according to the invention, in which:
Figure 3a shows a time dependent amplitude variation of the detected baseband FM modulation signal, or audiosignal with DC component;
Figure 3b shows the signal of Figure 3a without DC component;
Figure 3c the signal of Figure 3b after being rectified;
Figure 3d the signal of Figure 3c after being non-linearly amplified, which signal is being used as a timeconstant control signal;
Figure 3e the timedependent IF level signal;
Figure 3f the time dependent undistorted audiosignal.

Figure 1 shows an FM receiver for executing the method according to invention, having an RF front end 1 to tune the receiver onto a wanted RF FM signal and to demodulate the same into an IF FM signal, being subsequently coupled to an selective IF amplifier 2 to select and amplify the IF FM signal, an FM detector 3 for detecting the baseband FM modulation signal from the IF FM signal, which may comprise an FM stereomultiplex signal, a muting circuit 4 for attenuating the baseband FM modulation signal at the occurrence of FM demodulation noise at the output of the IF amplifier and a demultiplexer 5 to demultiplex the eventual stereomultiplex signal comprised by the baseband FM modulation signal at the output of the FM detector 3 into left and right stereosignals, which become available for reproduction into loudspeakers (not shown) at left and right sterosignal terminals L and R. The demultiplexer 5 can be dispensed with in case the FM receiver is to process monosignals only. The muting circuit 4 may be formed e.g. by a variable amplifier or attenuator and is provided with a mute control terminal 4' for supplying thereto a mute control signal to vary the attenuation or gain of the muting circuit 4.

The mute control signal is derived from the filtered IF signal at the output of the IF amplifier 2 by means of an IF level detector 6 followed by a variable first lowpass filter 7. The IF level detector 6 detects the level of the IF signal at the output of the selective IF amplifier 2, which thereafter is filtered in the variable lowpass filter 7. This variable lowpass filter 7 comprises a lowpass RC filter element constituting a timeconstant and therewith a signal delay, having a serial resistor and a mass connected capacitor. The resistor is variable by means of a timeconstant control signal supplied to a timeconstant control terminal 7' of this variable lowpass filter 7. An output of the lowpass filter 7 is coupled to a mute control terminal 4' of the muting circuit 4. Any decrease of the IF signal level below a certain threshold value will effect an attenuation of the baseband FM modulation signal in the muting circuit 4 resulting in the reproduced audiosignal being muted. The timeconstant of the mute control is determined by the timeconstant of the variable lowpass filter 7.

The description of the receiver according to the invention, given sofar, also reads on the receiver known from the above cited US Patent 5,410,751 with the exception that the lowpass filter 7 therein is not variable, i.e. timeconstant thereof is chosen at a fixed value.

The problems occurring in this known receiver, for which the invention provides a solution, are explained with reference to Figure 2.

Figure 2 a-c shows how IF FM signals carrying a modulation signal with deviations of the momentary frequency of the IF signal from the IF carrier frequency at t1 and t2 (see Figure 2a), which are large enough to cross the filter slope frequency areas (see Figure 2b), result in a periodical decrease of the IF signal level at the input of the lowpass filter 7 (figure 2c). For modulation frequencies of the IF modulation signal above the cut-off frequency of the lowpass filter 7, these periodical decreases will be blocked by the lowpass filter 7, therewith preventing the muting circuit 4 to attenuate or mute the baseband FM modulation signal and/or the audio signal included therein. However, for modulation frequencies of the IF modulation signal below the cut-off frequency of the lowpass filter 7, these periodical decreases will be smoothened and passed through to the mute control terminal 4' of the muting circuit 4, therewith effecting an attenuation or mute of the baseband FM modulation signal and/or the audio signal included therein. This results in signal distortions at t1 and t2 as shown in Figure 2d.

Lowering the timeconstant of the lowpass filter 7 would prevent such distortions from occurring, however, at the same time would delay the mute control to such extent that mute actions are avoided also at the occurrence of audible FM noise. This would deteriorate the overall noise performance of the receiver.

According to the invention, the timeconstant in the mute control signal of the receiver of Figure 1 is controlled with a timeconstant control signal derived from the detected baseband FM modulation signal. For this, the receiver comprises a baseband FM modulation signal level detector 8 being coupled between an output of the FM detector 3 and the timeconstant control terminal 7' of the variable first lowpass filter 7 for varying the timeconstant of this lowpass filter 7 dependent on the level of the baseband FM modulation signal. In the receiver shown, the baseband FM modulation signal level detector 8 comprises subsequently coupled to said output of the FM detector 3: a DC blocking filter 9 for blocking DC components in the baseband FM modulation signal at the output of the detector 3, a rectifier 10 having lowpass filter functionality to rectify and select and/or smoothen the baseband FM modulation signal, therewith obtaining a signal, reflecting the deviation of the momentary frequency of the IF signal from the IF carrier frequency, followed by a non-linear amplifier 11 to allow to more accurately adjust the timeconstant variation of the mute control to the occurrence of FM noise as a function of the deviation of the momentary frequency of the IF signal from the IF carrier frequency.

Figures 3 a-f show in more detail the effect of the measures according to the invention on the muting response of the receiver of Figure 1.

Figure 3a shows an amplitude variation of the detected baseband FM modulation signal, or audiosignal a as the case may be, at the output of the FM detector 3 in Figure 1. This amplitude variation signal a reflects the variation of the momentary frequency of the IF signal from the IF carrier frequency and is supplied to the DC blocking filter 9. This DC blocking filter 9 removes any unwanted DC component in signal a, therewith obtaining signal b shown in Figure 3b. The amplitude of signal 3b averagely varies around zero level. As such unwanted DC components are mainly occurring in an analog implementation of the receiver, due to tolerances in the value of the various analog circuit elements, the DC blocking filter 9 can be dispensed with in a digital implementation of the FM detector 3.

Signal 3b is rectified in the rectifier 10, resulting in a dual phase rectified signal 3c shown in Figure 3c representing the absolute value or magnitude of the frequency deviation of the momentary IF signal from the IF carrier frequency. Signal 3c is amplified with non-linear gain in the non-linear amplifier 11, resulting in a timeconstant control signal d - shown in Figure 3d -, which is supplied to the timeconstant control terminal 7' of the variable lowpass filter 7 to vary the timeconstant thereof. The non-linear amplification of the signal 3c is to level the timeconstant control signal d for excursions of the momentary frequency of the IF signal within the passband of the selective IF amplifier and to accentuate the amplitude variations of this timeconstant control signal d corresponding to excursions of the momentary frequency of the IF signal across the slope areas of the Selective IF amplifier, where muting of FM signals with low modulation frequencies gives rise to signal distortions and should be avoided.

Under control of this timeconstant control signal d an output signal e of the IF level detector as shown in Figure 3e is filtered in the variable lowpass filter 7 with a timeconstant varying in accordance with signal d. The signalcurves e and d show, that at any decrease in the IF signal level resulting from filterside suppression in the IF amplifier 2 and giving rise to an amplitude drop in signal e, the timeconstant of the variable lowpass filter is increased. This results in the mute response being delayed, therewith disabling the muting circuit 4 to respond to such IF signal level decreases. The baseband FM modulation signal and the audiosignal derived therefrom is therewith prevented from being distorted, even at low modulation frequencies of the IF signal.

The timeconstant is relatively small for deviations of the momentary frequencies within the passband of the selective IF amplifier 2, therewith keeping the mute response alert for suppressing FM demodulation noise. The overall mute response achieved with the variable lowpass filter 7 is reflected in signal f showing an appropriate lack of mute response in situations, where the IF signal level decreases are caused by IF filter side suppression.

It should be noted that the invention is not limited to the embodiment shown in Figure 1. As mentioned before, the invention may well be used without the DC blocking filter 9, but also without the non-linear amplifier 11 and/or the demultiplexer 5.

## Claims

1. Method for noise reduction during FM reception comprising the steps of:
- attenuating a detected audio signal,
- deriving a fieldstrength indicative muting control signal from an IF signal,
- controlling the step of attenuating the audio signal using the muting control signal,
when the fieldstrength decreases below a certain threshold level, said method being **characterized by** a timeconstant in the mute control signal being increased with an increasing deviation of the momentary frequency of the received FM signal from the FM carrier frequency and vice versa.

2. Method according to claim 1, **characterized in that** the timeconstant in the mute control signal is controlled with a timeconstant control signal derived from the detected baseband FM modulation signal by rectifying the detected baseband FM modulation signal.

3. Method according to claim 2, **characterized in** the derivation of the timeconstant control signal the audio signal is non-linearly amplified.

4. Receiver for executing the method according to claim 1, having an RF front end (1) being subsequently coupled to a selective IF amplifier (2), an FM detector (3) for detecting a baseband FM modulation signal comprising an audio signal, a muting circuit (4) which attenuates the audio signal, the muting circuit (4) having a mute control terminal (4') for supplying thereto said mute control signal, the IF amplifier (2) being coupled through an IF level detector (6) and a lowpass filter (7) to the mute control terminal of the muting circuit (4), **characterized by** a baseband FM modulation signal level detector (8) being coupled between an output of the FM detector (3) and a timeconstant control terminal (7') of the lowpass filter (7) for varying the timeconstant of the lowpass filter (7) dependent on the level of the baseband FM modulation signal.

5. Receiver according to claim 4 for executing the method of claim 2, **characterized in that** the baseband FM modulation signal level detector (8) comprises a rectifier (10) including lowpass filter (7) functionality.

6. Receiver according to claim 4 or 5, **characterized in that** the baseband FM modulation signal level detector (8) comprises a non-linear amplifier (11) coupled to the rectifier circuit (10) and included between the output of the FM detector (3) and the timeconstant control terminal (7') of the muting circuit (4).

7. Receiver according to one of claims 4 to 6, **characterized in that** the FM modulation signal level detector (8) comprises a DC blocking filter (9) coupled to said output of the FM detector (3).

## Patentansprüche

1. Verfahren zur Rauschminderung während des FM-Empfangs, mit den folgenden Schritten:
- Dämpfen eines detektierten Audiosignals,
- Ableiten eines Feldstärke anzeigenden Stummschaltungssteuersignals aus einem ZF-Signal,
- Steuern des Schritts des Dämpfens des Audiosignals unter Verwendung des Stummschaltungssteuersignals, wenn die Feldstärke unter einen bestimmten Schwellenpegel abnimmt, wobei das Verfahren **dadurch gekennzeichnet ist, daß** eine Zeitkonstante in dem Stummschaltungssteuersignal bei einer zunehmenden Abweichung der Momentanfrequenz des empfangenen FM-Signals von der FM-Trägerfrequenz vergrößert wird und umgekehrt.

2. Verfahren nach Anspruch 1, **dadurch gekennzeichnet, daß** die Zeitkonstante in dem Stummschaltungssteuersignal mit einem zeitkonstanten Steuersignal gesteuert wird, das aus dem detektierten Basisband-FM-Modulationssignal durch Gleichrichten des detektierten Basisband-FM-Modulationssignals abgeleitet wird.

3. Verfahren nach Anspruch 2, **dadurch gekennzeichnet, daß** bei der Ableitung des zeitkonstanten Steuersignals das Audiosignal nichtlinear verstärkt wird.

4. Empfänger zur Ausführung des Verfahrens nach Anspruch 1 mit einem HF-Frontend (1), nachfolgend angekoppelt an: einen selektiven ZF-Verstärker (2), einen FM-Detektor (3) zum Detektieren eines ein Audiosignal umfassenden Basisband-FM-Modulationssignals, eine Stummschaltung (4), die das Audiosignal dämpft, wobei die Stummschaltung (4) einen Stummschaltungssteueranschluß (4') aufweist, dem das Stummschaltungssteuersignal zugeführt wird, wobei der ZF-Verstärker (2) durch einen ZF-Pegeldetektor (6) und ein Tiefpaßfilter (7) an den Stummschaltungssteueranschluß der Stummschaltung (4) angekoppelt ist, **dadurch gekennzeichnet, daß** ein Basisband-FM-Modulationssignalpegeldetektor (8) zwischen einen Ausgang des FM-Detektors (3) und einen zeitkonstanten Steueranschluß (7') des Tiefpaßfilters (7) geschaltet ist, um die Zeitkonstante des Tiefpaßfilters (7) abhängig von dem Pegel des Basisband-FM-Modulationssignals zu variieren.

5. Empfänger nach Anspruch 4 zum Ausführen des Verfahrens nach Anspruch 2, **dadurch gekennzeichnet, daß** der Basisband-FM-Modulationssignalpegeldetektor (8) einen Gleichrichter (10) einschließlich Funktionalität eines Tiefpaßfilters (7) umfaßt.

6. Empfänger nach Anspruch 4 oder 5, **dadurch gekennzeichnet, daß** der Basisband-FM-Modulationssignalpegeldetektor (8) einen nichtlinearen Verstärker (11) umfaßt, der an die Gleichrichterschaltung (10) angekoppelt und zwischen dem Ausgang des FM-Detektors (3) und dem zeitkonstanten Steueranschluß (7') der Stummschaltung (4) vorgesehen ist.

7. Empfänger nach einem der Ansprüche 4 bis 6, **dadurch gekennzeichnet, daß** der FM-Modulationssignalpegeldetektor (8) ein an den Ausgang des FM-Detektors (3) angekoppeltes Gleichstromsperrfilter (9) umfaßt.

## Revendications

1. Procédé de réduction du bruit pendant une réception FM, comprenant les étapes consistant à :
- atténuer un signal audio détecté,
- dériver un signal de réglage de silence représentatif de l'intensité de champ à partir d'un signal IF,
- régler l'étape d'atténuation du signal audio en utilisant le signal de réglage de silence,
lorsque l'intensité de champ diminue au-dessous d'un certain niveau de seuil, ledit procédé étant **caractérisé par** une constante de temps dans le signal de réglage de silence qui est augmentée avec une augmentation de l'écart de la fréquence momentanée du signal FM reçu par rapport à la fréquence porteuse FM et vice versa.

2. Procédé selon la revendication 1, **caractérisé en ce que** la constante de temps dans le signal de réglage de silence est réglée à l'aide d'un signal de réglage de constante de temps dérivé du signal de modulation FM de bande de base détecté en redressant le signal de modulation FM de bande de base détecté.

3. Procédé selon la revendication 2, **caractérisé en ce que** l'écart entre le signal de réglage de constante de temps et le signal audio est amplifié non linéairement.

4. Récepteur pour exécuter le procédé selon la revendication 1, possédant un étage d'entrée RF (1) couplé ensuite à un amplificateur IF sélectif (2), un détecteur FM (3) pour détecter un signal de modulation FM de bande de base comprenant un signal audio, un circuit de silence (4) qui atténue le signal audio, le circuit de silence (4) possédant une borne de réglage de silence (4') pour délivrer à celui-ci ledit signal de réglage de silence, l'amplificateur IF (2) étant couplé à la borne de réglage de silence du circuit de silence (4) par l'intermédiaire d'un détecteur de niveau IF (6) et d'un filtre passe-bas (7), **caractérisé par** un détecteur de niveau de signal de modulation FM de bande de base (8) couplé entre une sortie du détecteur FM (3) et une borne de réglage de constante de temps (7') du filtre passe-bas (7) pour faire varier la constante de temps du filtre passe-bas (7) en fonction du niveau du signal de modulation FM de bande de base.

5. Récepteur selon la revendication 4 pour exécuter le procédé de la revendication 2, **caractérisé en ce que** le détecteur de niveau de signal de modulation FM de bande de base (8) comprend un redresseur (10) incluant une fonctionnalité de filtre passe-bas (7).

6. Récepteur selon la revendication 4 ou 5, **caractérisé en ce que** le détecteur de niveau de signal de modulation FM de bande de base (8) comprend un amplificateur non linéaire (11) couplé au circuit redresseur (10) et inclus entre la sortie du détecteur FM (3) et la borne de réglage de constante de temps (7') du circuit de silence (4).

7. Récepteur selon l'une des revendications 4 à 6, **caractérisé en ce que** le détecteur de niveau de signal de modulation FM (8) comprend un filtre de blocage DC (9) couplé à ladite sortie du détecteur FM (3).
